Europäisches Patentamt

European Patent Office

Office européen des brevets

(19)

(11) Publication number: **0 040 379**

**A1**

(12) # EUROPEAN PATENT APPLICATION

(21) Application number: 81103553.4

(22) Date of filing: 09.05.81

(51) Int. Cl.³: **H 05 K 3/36**
**H 05 K 3/34**

(30) Priority: 19.05.80 US 151209

(43) Date of publication of application:
25.11.81 Bulletin 81·47

(84) Designated Contracting States:
DE FR GB

(71) Applicant: GENERAL ELECTRIC COMPANY
1 River Road
Schenectady New York 12305(US)

(72) Inventor: Clark, Roland Everett
14 Riverview Place
Lynchburg Virginia(US)

(74) Representative: Schüler, Horst, Dr. et al,
Kaiserstrasse 41
D-6000 Frankfurt Main 1(DE)

(54) Improved printed wire board sub-assembly for a hybrid thick film circuit.

(57) Electrical components are (33...37) mounted between two printed wire boards (31,32) with the component leads (40,41) positioned in holes in the boards and soldered to conductor patterns (42,43) on the boards (31,32). The conductor patterns (42,43) extend around the lower edge of each board. The boards and components form a subassembly (10) which is positioned on solder pads (50) on the ceramic substrate (14) of a hybrid thick film circuit (12). The hybrid thick film circuit (12) is heated from below the substrate (14) to cause the solder pads (50) to melt and reflow to the conductor patterns (42,43) on the lower edges of the printed wire boards (31,32). When the solder cools, the subassembly (10) is mechanically and electrically connected to the hybrid thick film circuit (12).

EP 0 040 379 A1

FIG. I

10076-45-MR-248

IMPROVED PRINTED WIRE BOARD SUBASSEMBLY FOR A
HYBRID THICK FILM CIRCUIT

My invention relates to a hybrid thick film circuit, and particularly to a printed wire board subassembly for use in combination with a hybrid thick film circuit.

Hybrid thick film circuits are used in electronic or radio devices to provide a particular function or system for the electronic or radio device. At the present state of the art, it is difficult to mount some components, such as coils, discrete capacitors, crystals, or potentiometers, on the ceramic substrate of the hybrid thick film circuit. This difficulty has resulted, at least in part, from the fact that the leads of such components require holes through the ceramic substrate for receiving the leads and permitting them to be soldered to the conductive patterns on the substrate. The substrates used are typically a very hard ceramic material, so that holes can usually be provided with a laser beam which frequently causes microcracks which weakens the material. Even if holes can be provided in the ceramic substrate and the component leads soldered, it is frequently difficult to get access to those components which must be tuned or adjusted. This difficulty may be increased after the hybrid thick film circuit is positioned on its larger circuit board.

The invention is concerned with a hybrid thick film circuit which enables subassembly of one or more passive electrical components.

The invention also provides a new and improved discrete component subassembly for mounting on the substrate of a hybrid thick film circuit and for connecting the components to the circuit on the substrate without the need for holes through the substrate.

A component subassembly is provided that is easily soldered to a hybrid thick film circuit in one reflow operation without damage to the electrical components, and that permits relatively easy adjustment of the components after soldering.

Briefly, these and other features are achieved in accordance with the invention by a subassembly comprising a

-3-

pair of insulating printed wire boards between which one or more components are positioned. The component leads are soldered to printed circuit patterns on the major surfaces of the printed wire boards. The subassembly is positioned on solder pads on the substrate of the hybrid thick film circuit, with the printed wire boards substantially perpendicular to the substrate, and with selected solder coated printed circuit patterns on the printed wire board engaging selected solder pads. The hybrid thick film circuit is heated from beneath so that the solder (of the patterns and pads) melts and flows to electrically join the patterns to the pads. When the solder cools, the subassembly is securely and mechanically held on the hybrid thick film circuit.

The structure and operation of the invention, together with further features and advantages, may be better understood from the following description given in connection with the accompanying drawing, in which:

FIGURE 1 shows a perspective view of a printed wire board subassembly in accordance with the invention, mounted on the substrate of a hybrid thick film circuit;

FIGURE 2 shows an end elevation view of subassembly and the hybrid thick film circuit of FIGURE 1; and

FIGURE 3 shows an enlarged cross-sectional view of a portion of the subassembly and the hybrid thick film circuit of FIGURE 1.

-4-

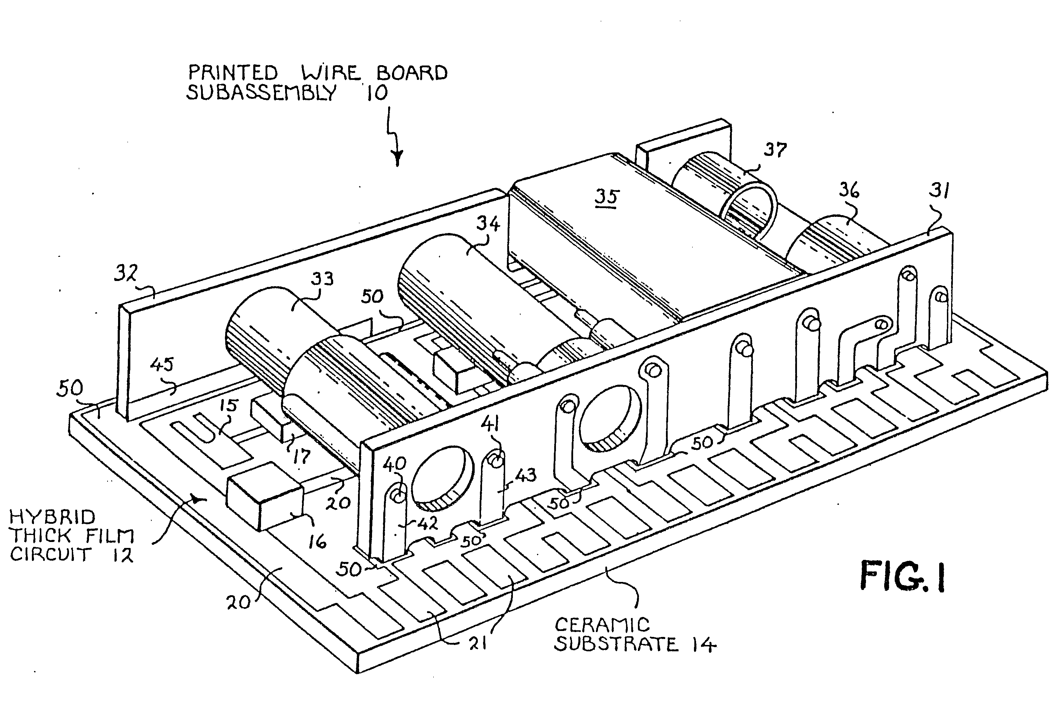

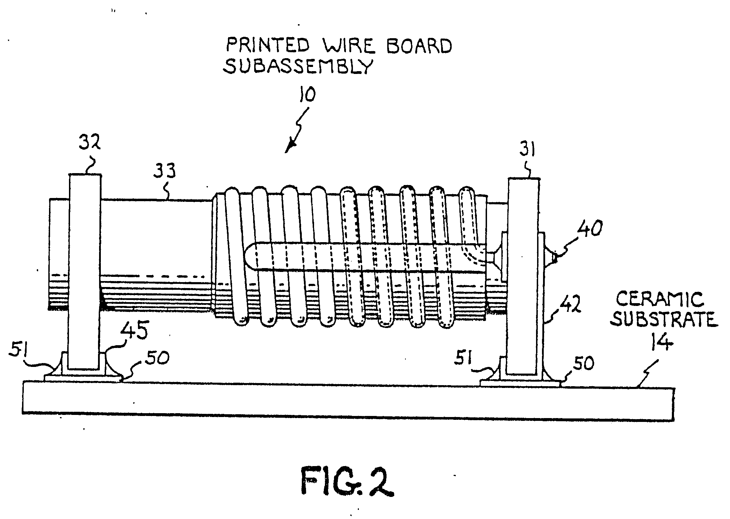

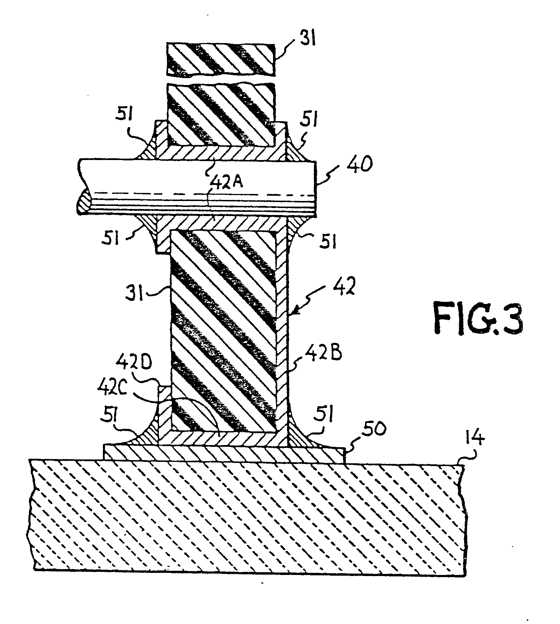

With reference to FIGURES 1, 2, and 3, printed wire board subassembly 10 in accordance with invention positioned on a hybrid thick film circuit 12. Before describing the subassembly 10, the hybrid thick film circuit 12 will be described. As known in the art, this circuit 12 is mounted on a fired ceramic substrate 14. The ceramic substrate 14 is provided with metallic leads or runs 20, pads 50, and contacts 21 which are deposited on the substrate 14 in the desired configuration. These metallic deposits are then fired, and solder is applied to the leads or runs 20, and to the pads 50, but not to the contacts 21. Various electrical components, such as a trimmable resistor 15, a capacitor 16, a solid state device transistor 17, and various other components, some of which are shown by way of example in FIGURE 1, are placed on the runs 20. These components are omitted from FIGURES 2 and 3 for clarity. After the components are mounted, the substrate 14 is heated so that the solder reflows and connects the components to the metallic runs or leads 20 deposited on the substrate 14. Connections to an external circuit are provided by the metallic contacts 21.

Except for the pads 50, the hybrid thick film circuit 12 as described thus far is known in the art. Typically, the ceramic substrate 14 is made of a ceramic material such as alumina which is relatively hard and difficult to machine, particularly after it has been fired during its manufacture. Accordingly, it is very difficult to provide holes through the substrate 14 without recourse to costly laser drilling equipment for mounting discrete electrical components, such as coils, capacitors, piezoelectric crystals, potentiometers, or other similar electrical devices. In order to eliminate many of the problems associated with mounting and connecting electrical components to a typical hybrid thick film circuit 12, I provide the printed wire board subassembly 10 as shown in FIGURES 1 and 2. the subassembly 10 includes or comprises a first printed wire board 31 and a second printed wire board 32 made of any suitable insulating, machinable material such as resin bonded fiberglass laminate. The boards 31, 32 are preferably positioned so that their major surfaces are perpendicular or transverse to a common plane, in this case the plane of the ceramic substrate 14. While it may be desirable that the boards 31, 32 also be parallel to each other, this is not necessary. The subassembly 10 shown in FIGURE 1, includes by way of example only a first adjustable coil 33, a second adjustable coil 34, a piezoelectric crystal 35, and an adjustable potentiometer 36 having an access sleeve or grommet 37. The leads or wires from these electrical components are positioned in suitable drilled holes or openings in the first board 31. Associated with the lead holes are metallic circuit patterns deposited on or formed by chemically etching away parts of a metallic coating bonded to the first board 31. These patterns are usually made of copper foil and have a solder coating. These circuit patterns extend from the holes down the outer major surface of the board 31 to the lower board edge, across this lower edge, and upward across the interior major surface of the board 31 for a short distance. This extension of the patterns across the lower edge and up the inner surface for a short distance provides an integral and stronger construction. With respect to the first coil 33, its leads are indicated by the numerals 40, 41. These leads 40, 41 extend through appropriately positioned holes in the circuit board 31. Conductor runs or patterns 42, 43 extend from the holes for the leads 40, 41 downward to the bottom of the board 31, across its lower edge, and up a short distance on the inner surface of the board 31. As shown in FIGURE 3 for the pattern 42 of the coil lead 40, I prefer that the holes also be plated as at 42A. This plating 42A is connected to the pattern which extends down along 42B, across the lower edge along 42C, and up along 42D. Similar holes and patterns are appropriately provided for the other components as shown in FIGURE 1.

I have assumed that the second printed wire board 32 does not have to provide any connections or component patterns. However, it is to be understood that the second board 32 may provide such connections or patterns as described for the first board 31. Accordingly, for the assumed condition, the ends of the components 33, 34, 35 and the sleeve 37 are merely fastened or connected to the second board 32 by any suitable means, such as mechanical fasteners or cementing with epoxy. The second board 32 is provided with suitable attachment patterns 45 near the lower part of its major surfaces and across its lower edge. These patterns are also solder coated.

In accordance with the invention, it is preferred that the printed wire board subassembly 10 be completed before it is mounted on the ceramic substrate 14 of the hybrid thick film circuit 12. While there are various ways in which the subassembly 10 can be constructed, I prefer that the various components be mounted on the first board 31 with its drilled holes and patterns, and their leads connected and soldered (usually by hand) to the appropriate circuit patterns. The first board 31 with the attached components can then be mounted in a suitable fixture, and the second board 32 placed in the same fixture adjacent the other ends of the components, held in the proper position, and cemented or connected to those components by any suitable means. After the component leads have been soldered to the first board and the other ends of the components attached to the second board 32, the resulting structure is relatively strong and forms my printed wire board subassembly 10. This subassembly 10 is placed on the hybrid thick film circuit 12 so that the conductor patterns 42 and attaching patterns 45 are positioned in engagement with appropriate solder pads 50 on the ceramic substrate 14. The solder pads 50 are positioned on the substrate 14 at appropriate locations to correspond to the patterns 42 on the board 31 and the patterns 45 on the board 32. These locations may be in a row of individual pads for respective connections to leads or runs on the substrate 14, or may be continuous for a single connection or attachment. The hybrid thick film circuit 12 is then preheated from below at a temperature of approximately 200 degrees centigrade for ten seconds, then is heated from below at a temperature of approximately 275 degrees centigrade for ten seconds, and then is rapidly cooled. The preheating prevents rapid temperature shock to the various components and elements, and the heating at the 275°C temperature causes the solder on the conductor patterns 42, 43, on the attaching patterns 45, and on the solder pads 50

-8-

to melt, and to flow and connect the patterns 42, 43, 45 to the solder pads 50. After the assembly is cooled, the solidified solder (indicated at 51) provides good electrical connections and strong mechanical attachment for the subassembly 10 and the hybrid thick film circuit 12. It is preferred that the hybrid thick film circuit 12 with its printed wire board subassembly 10 be placed on a conveyor belt of any suitable material and passed over an electric hot plate which provides the desired temperatures. The speed of the conveyor belt determines the exposure to those temperatures. I also prefer that the heat for the two steps be applied from beneath the ceramic substrate 14 so that it does not reach the various circuit components, particularly the plastic pieces on which the coils and other elements may be wound or mounted. As shown in FIGURE 2, the various circuit components are mounted on the boards 31, 32 above the substrate 14 so that an air space with its good heat insulation is provided to protect the various circuit components. The ceramic substrate 14 is a relatively good heat conductor, and causes the solder on its pads 50 and on the patterns 42, 43, 45 to melt quickly and flow together for good connection and strength. The strength results from the reflowed and cooled solder, particularly between the lower edge of the boards 31, 32 and the pads 50, and also by the fillets 51 (exaggerated for emphasis) at the intersections of the board surfaces and the pads 50.

After the subassembly 10 is connected to the hybrid thick film circuit 12, the resulting unit may be handled in typical manufacturing conditions without danger of damage to the various components. And as will be seen, the components

-9-

are relatively accessible, and may be easily adjusted to provide the desired electrical characteristics. After tuning, the completed unit may be housed or packaged in any suitable container, and connected to an appropriate electrical circuit through its contacts 21.

It will thus be seen that a new and improved printed wire board subassembly is provided which permits electrical components to be mounted on a ceramic substrate of a hybrid thick film circuit without the necessity of drilling holes in the ceramic substrate. In addition, my subassembly permits independent construction of the subassembly and connection by hand soldering, after which the subassembly is efficiently attached and connected to the hybrid thick film circuit by heating the circuit from beneath its ceramic substrate. While only one embodiment of the invention has been shown, persons skilled in the art will appreciate the modifications that may be made. For example, it may be desirable to have only a relatively small number of circuit patterns soldered or connected to the solder pads. The exact number depends upon design preferences and strengths required. Likewise, the component leads may be connected to both printed wire boards, or alternately to the printed wire boards, in any desired configuration. Various machinable insulating materials may be used for the boards. Therefore, while the invention has been described with reference to a particular embodiment, it is to be understood that modifications may be made without departing from the spirit and scope of the invention.

10076-45-MR-248

CLAIMS:

1. An improved hybrid thick film circuit comprising, in combination:

a ceramic substrate having pads of solder positioned on a major surface thereof in selected locations;

a subassembly comprising first and second insulating boards, each of said boards having conductor patterns which include solder and which are positioned on at least one major surface thereof in the vicinity of at least one edge thereof;

said first and second insulating boards being held in spaced relation by attachment to at least one electrical component positioned therebetween, said component having leads in engagement with selected conductor patterns respectively;

said first and second insulating boards being positioned on said ceramic substrate with said one edge of each of said insulating boards in engagement with at least one solder pad respectively;

and reflowed solder connecting selected ones of said conductor patterns to selected ones of said solder pads respectively, said reflowed solder further mechanically holding said insulating boards on said substrate.

2.    The improved circuit of claim 1 wherein said major surfaces of said insulating boards are substantially perpendicular to said major surface of said ceramic substrate.

3.    The improved circuit of claim 1 or claim 2 wherein selected component leads are soldered to selected conductor patterns respectively.

4.    The improved circuit of claim 1 or claim 2 wherein said conductor patterns are selectively positioned on said one edge of said insulating board.

5.    The improved circuit of claim 3 wherein said conductor patterns are selectively positioned on said one edge of said insulating board.

6.    An improved subassembly for use on the substrate of a hybrid thick film circuit having at least two solder pads positioned thereon, said subassembly comprising:

first and second insulating boards each having two major faces bounded by edges, at least one of which is substantially straight;

said first insulating board having holes therethrough and solderable conductor patterns thereon at selected locations;

said conductor patterns being positioned on at least one face of said one board, and selected ones of said conductor patterns extending from said one face across said substantially straight edge of said first board;

said conductor patterns being positioned on said one straight edge to conform with the locations of selected solder pads on a substrate of a hybrid thick film circuit;

said second insulating board having at least one solderable area positioned on said one straight edge thereof;

said solderable area of said second board being positioned to conform with the location of a selected solder pad on said substrate of said hybrid thick film circuit;

and at least one electrical component having leads extending through selected holes in said first insulating board and being soldered to respective conductor patterns to attach said electrical component to said first insulating board, said electrical component being attached to said second insulating board.

7. The improved subassembly of claim 6 wherein said first and second insulating boards are positioned with said faces thereof substantially perpendicular to a common plane after being attached to said electrical component.

8. The improved subassembly of claim 6 or claim 7 wherein said electrical component is attached to said second insulating board by cement or the like.

PRINTED WIRE BOARD
SUBASSEMBLY 10

HYBRID
THICK FILM
CIRCUIT 12

CERAMIC
SUBSTRATE 14

FIG.1

PRINTED WIRE BOARD
SUBASSEMBLY

10

32    33    31    40    42

CERAMIC
SUBSTRATE
14

51    45    50    51    50

FIG. 2

0040379

FIG.3

European Patent Office

**EUROPEAN SEARCH REPORT**

## DOCUMENTS CONSIDERED TO·BE RELEVANT

| Category | Citation of document with indication, where appropriate, of relevant passages | Relevant to claim |
|---|---|---|
| | US - A - 3 725 744 (REED)<br>* column 2, line 54 to column 3, line 45; fig. 1 to 3 *<br>-- | 1-8 |
| | DE - A1 - 2 849 610 (COMATEL)<br>* page 2, line 1 to page 3, line 17 *<br>-- | 1 |
| | IBM TECHNICAL DISCLOSURE BULLETIN,<br>Vol. 20, No. 11A, April 1978<br>R.A. HENLE "Vertical Chip Packaging"<br>pages 4339 , 4340<br>* page 4340, lines 21 to 25; fig. 2 * | 1,2,4,<br>5,6 |

**CLASSIFICATION OF THE APPLICATION (Int. Cl.³)**

H 05 K    3/36

H 05 K    ·3/34

**TECHNICAL FIELDS SEARCHED (Int. Cl.³)**

H 05 K    3/34

H 05 K    3/36

**CATEGORY OF CITED DOCUMENTS**

X: particularly relevant
A: technological background
O: non-written disclosure  .
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| Berlin | ·14-08-1981 | ·HAHN |

EPO Form 1503.1   06.78